Europäisches Patentamt

European Patent Office

Office européen des brevets

(11) Publication number: **0 338 125**
**A1**

## (12) EUROPEAN PATENT APPLICATION

(21) Application number: 88120110.7

(22) Date of filing: 02.12.88

(51) Int. Cl.⁴: **H03D 7/00** , **H04B 1/12**

(30) Priority: 20.04.88 US 183856

(43) Date of publication of application:
25.10.89 Bulletin 89/43

(84) Designated Contracting States:
**DE FR GB IT**

(71) Applicant: **Hewlett-Packard Company**
**P.O. Box 10301 3000 Hanover Street**
**Palo Alto California 94303-0890(US)**

(72) Inventor: **Bartz, Manfred U.**
**2620 136th Street**
**Bothell, WA 98012(US)**

(74) Representative: **Patentanwälte Kohler -**
**Schwindling - Späth**
**Hohentwielstrasse 41**
**D-7000 Stuttgart 1(DE)**

(54) **Method and apparatus for nulling local oscillator feedthrough.**

(57) A method and apparatus for nulling local oscillator feedthrough, suitable for use in superheterodyne receivers, is disclosed. A local oscillator (10) produces a signal ($V_{LO}$) that is split by a signal splitter (12) into two signals ($V_1$ and $V_2$). $V_1$ is mixed with an input signal ($V_s$) by a mixer (30), producing a mixed signal ($V_m$). $V_2$ bypasses the mixer (30) by way of a feedforward circuit (38) and is modified by a polarity and amplitude control circuit (16) and a low-pass filter and phase control circuit (18). The output of the feedforward circuit (38) is a nullifying signal ($V_2'$). $V_2'$ is combined with an amplifier mixed output signal ($V_m'$) in a signal combiner (34) to produce a combined signal ($V_c$) that contains a minimized local oscillator feedthrough component ($V_1'$ component). Digital-to-analog converters (20) and (22) convert control data produced by a microprocessor (24) into analog control signals ($V_a$ an $V_p$) for controlling the polarity and amplitude control circuit (16) and the low-pass filter and phase control circuit (18). The polarity, amplitude and phase of $V_2'$ substantially nullifies the $V_1'$ components contained in $V_m'$.

Fig. 1.

# METHOD AND APPARATUS FOR NULLING LOCAL OSCILLATOR FEEDTHROUGH

## Technical Area

This invention relates to signal receivers and, more particularly, to superheterodyne receivers.

## Background of the Invention

Over the years, signal receivers have found broad applications in the consumer, commercial, and industrial markets. Applications range from simple radio receivers used for receiving transmissions from local broadcast stations to receivers used in signal analyzers designed to detect and analyze one or more complex signals in the presence of other signals. One type of signal receiver that has gained widespread acceptance is the superheterodyne receiver. In a superheterodyne receiver an incoming signal is subjected to a series of mixing and filtering steps. In a first step, or stage, of a superheterodyne receiver, an incoming signal is combined, i.e., mixed, with a locally generated, superaudible signal. The source of the locally generated signal is typically an oscillator, commonly called a local oscillator. The mixed signal is filtered by an intermediate frequency (I.F.) filter that is tuned to pass a signal at a known frequency. The known frequency is either the sum of the local oscillator signal frequency and the frequency of the signal being sought or the difference between the local oscillator signal and the frequency of the signal being sought. When the frequency of the signal being sought changes, the local oscillator signal changes in a compensating manner such that the intermediate frequency signal remains constant.

When the incoming signal is a low frequency signal (relative to the local oscillator signal), the frequency of both the sum and difference signals discussed above are close to the frequency of the local oscillator signal. Because filters are not perfect, i.e., they do not have a sharp cut off at the ends of their designed pass band, the first stage I.F. filter of a superheterodyne receiver passes a portion of the local oscillator signal. Thus, the chosen intermediate frequency signal is distorted, i.e., contains undesired noise. For example, if the local oscillator generates a 100 MHz signal and the signal to be detected has a frequency of 100 Hz, the intermediate frequency signals resulting from superheterodyne mixing are 99.9999 MHz and 100.0001 MHz. The first stage I.F. filter, as discussed above, is tuned to pass one of these two signals. The I.F. filter has a sloped cutoff allowing frequencies close to the nominal cutoff frequency to pass through the filter, albeit at a lower amplitude. In the above example, because of the close proximity of the local oscillator frequency to the chosen intermediate frequency (100 Hz), the I.F. filter will pass a portion of the local oscillator signal. The local oscillator component of the passed signal is referred to as local oscillator feedthrough. The presence of local oscillator feedthrough distorts the first mixer stage output. Such a distortion in the output of the first stage of a superheterodyne receiver makes the analysis of the signal by subsequent stages more difficult.

Past efforts to reduce the local oscillator feedthrough have traditionally concentrated upon improving the first stage mixer design and construction. Prior art improvements have in the design, layout and component specifications have resulted in low feedthrough mixers. However, the effectiveness of such prior art techniques have been limited by the cost effectiveness and the practical limitations associated with designing and constructing the improved circuits. Thus, despite the improvements made by the prior art, the problem of local oscillator feedthrough remains in superheterodyne receivers, particularly in superheterodyne receivers designed to detect low frequency signals.

As can be readily appreciated from the foregoing discussion there is a need for a cost effective method and apparatus for reducing local oscillator feedthrough in the first mixer stage of superheterodyne receivers, particularly superheterodyne receivers designed to process low frequency incoming signals. The present invention provides an apparatus for reducing the local oscillator feedthrough to levels below the current levels available with the prior art techniques in a cost effective manner.

## Summary of the Invention

In accordance with the present invention, local oscillator feedthrough is reduced by splitting the local oscillator signal. A portion of the local oscillator signal is mixed with the incoming signal in a conventional manner in the first stage mixer of a superheterodyne receiver. The remainder bypasses the first stage mixer. The bypass signal is modified in a feedforward circuit and the result combined with the first stage mixer output. Ideally, the modified bypass signal is equal in amplitude and phase and opposite in polarity to the local oscillator feedthrough component in the first stage mixer output. As a result, the bypass signal nulls the local oscillator feedthrough component, thereby reducing the local oscillator feedthrough to an acceptable level.

In further accordance with this invention, a microprocessor monitors the superheterodyne receiver output signal. If a local oscillator feedthrough component is detected in the receiver output, the microprocessor modifies feedback control signals applied to the feedforward circuit in a manner that causes the feedforward circuit to modify the bypass signal in a compensating manner.

As can be readily appreciated from the foregoing summary, the invention provides a method and apparatus for nulling local oscillator feedthrough in superheterodyne receivers that effectively overcomes the problems and practical limitations of prior art techniques designed to limit the effect of local oscillator feedthrough.

## Brief Description of the Drawings

The forgoing and other features and advantages of this invention will become more readily appreciated as the same becomes better understood by reference to the following detailed description, and when taken in conjunction with the accompanying drawings, wherein:

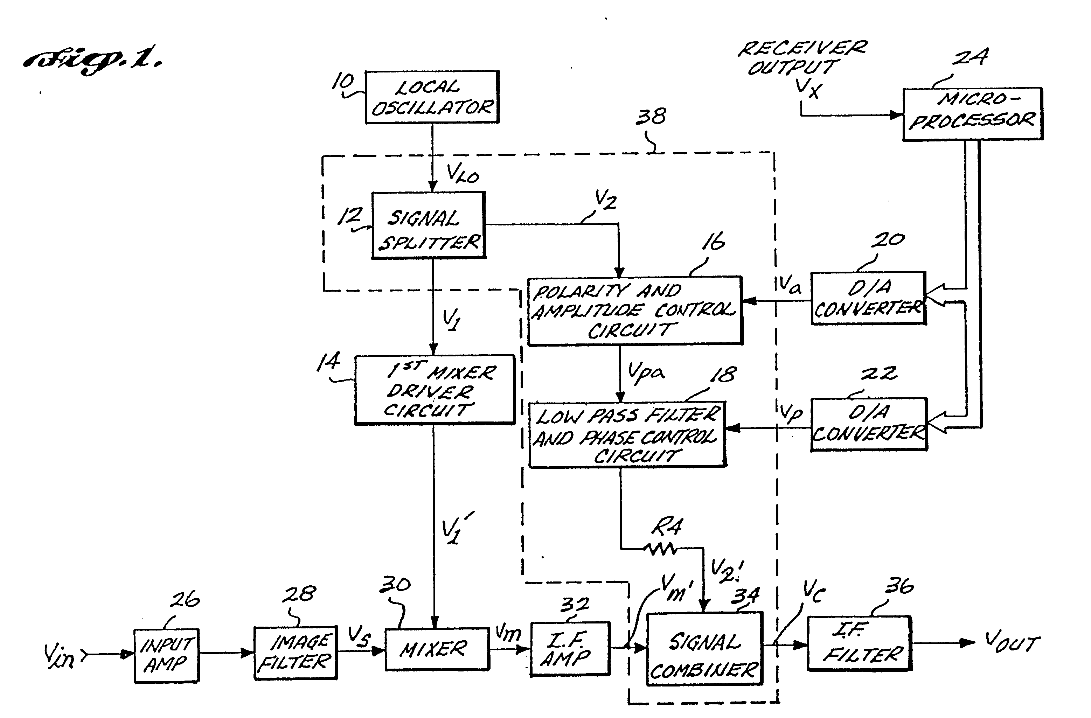

.FIGURE 1 is a block diagram of an apparatus formed in accordance with this invention;

FIGURE 2 is a schematic diagram of selected portions of the apparatus illustrated in FIGURE 1; and

FIGURE 3, lines A through F is a series of waveforms illustrating the shapes of various signals as they are processed by the apparatus illustrated in FIGURE 2.

## Description of the Preferred Embodiment

As is well-known to those skilled in the superheterodyne receiver art, there is a need to reduce the amount of local oscillator feedthrough in the first mixer stage of superheterodyne receivers, particularly superheterodyne receivers designed to receive and process low frequency signals. The present invention is designed to accomplish this result.

FIGURE 1 illustrates in block diagram form a first mixer stage of a superheterodyne receiver formed in accordance with the present invention. A local oscillator 10 produces a signal, $V_{LO}$, which is split, by a signal splitter 12, into two equal signals, $V_1$ and $V_2$. In a conventional manner, $V_1$ is amplified by a first mixer driver circuit 14 and, a resulting mixer drive signal, $V_1'$, is applied to one input of the mixer 30 of the first mixer stage. An incoming signal, $V_{in}$, is amplified by an input amplifier 26 and filtered by an image filter 28 yielding a signal, $V_s$. $V_s$ is applied to a second input of the mixer 30. The $V_s$ and $V_1'$ signals are mixed in the mixer 30. The result is a mixed signal $V_m$, which is amplified by an intermediate frequency (I.F.) amplifier 32 resulting in an amplified mixed signal, $V_m'$. In accordance with the invention, a signal combiner 34 combines $V_m'$ and a modified bypass (i.e., nullifying) signal, $V_2'$, derived from $V_2$, derived from $V_2$ in a feedforward circuit 38 described in detail below. The combined signal, $V_c$, is bandpass filtered by an I.F. filter 36 to produce a first mixer stage output signal, $V_{out}$. $V_{out}$ is applied to the next stage of the superheterodyne receiver. As will be better understood from the following description, $V_2'$ reduces local oscillator feedthrough by nulling local oscillator feedthrough present in $V_m'$.

In accordance with the invention, the feedforward circuit 38 routes $V_2$ around mixer 30. More specifically, $V_2$ is passed first through a polarity and amplitude control circuit 16 and then through a low-pass filter and phase control circuit 18, both of which modify $V_2$. The result of the modification is the modified bypass, or nullifying signal, $V_2'$. A microprocessor 24 monitors the superheterodyne receiver output signal, $V_x$. If, in the absence of a $V_{in}$ signal, $V_1'$ components are detected in $V_x$, the microprocessor 24 causes the feedforward circuit 38 to modify $V_2'$ in a compensating manner. More specifically, the microprocessor 24 sends digital signals to two digital-to-analog (D/A) converters, 20 and 22, which convert the digital signals into analog control signals, $V_a$ and $V_p$, respectively. $V_a$ is applied to the polarity and amplitude control circuit 16 and $V_p$ signal is applied to the low-pass filter and phase control circuit 18. As discussed more fully below, $V_a$ biases a pair of pin diodes in the polarity and amplitude control circuit. By varying the biasing of the diode pair, the polarity and amplitude of $V_2$ is varied. The polarity and amplitude adjusted $V_2$ signal, $V_{pa}$, is applied to the low-pass filter and phase control circuit 18. As also discussed more fully below, $V_p$ biases a pair of varactor diodes in the low-pass filter and phase control circuit 18. Varying the bias voltage on the diode pair causes the low-pass filter and phase control circuit 18 to phase shift $V_{pa}$, resulting in $V_2'$. Ideally, $V_2'$ has polarity, amplitude and phase characteristics such that when $V_2'$ is combined with $V_m'$, local oscillator feedthrough contained in $V_m'$ is nulled. In essence $V_2'$ is equal in magnitude, opposite in polarity and in phase with the $V_1'$ component of $V_m'$.

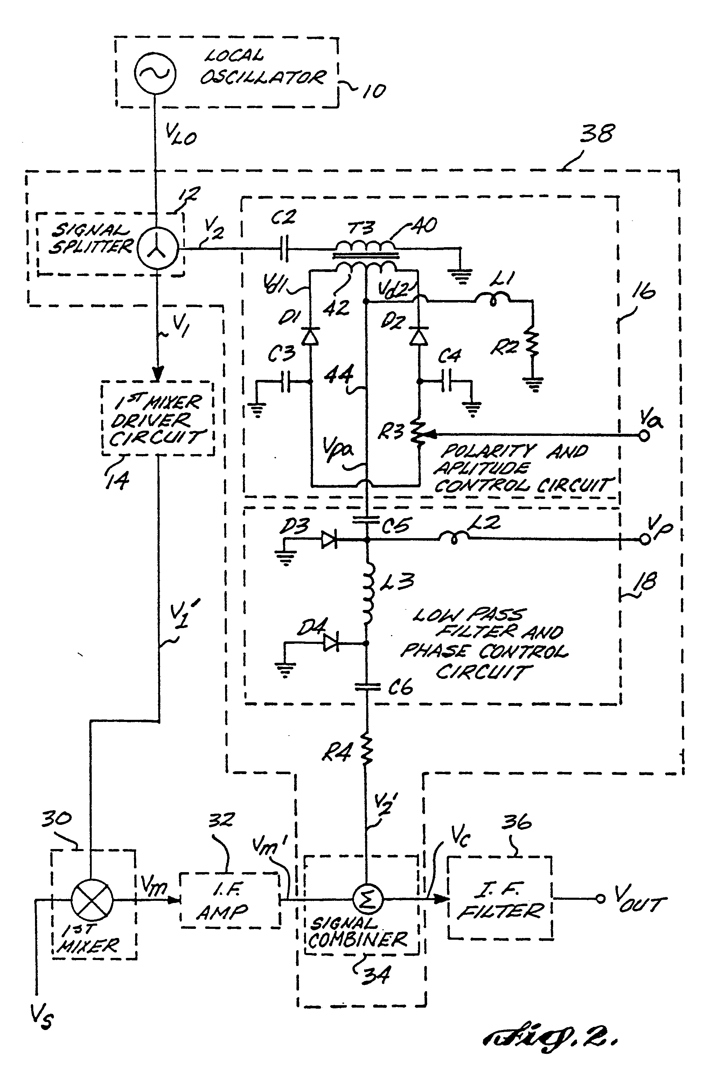

A feedforward circuit 38 is suitable for use in the embodiment of the invention illustrated in FIGURE 1 is illustrated in schematic form in FIGURE 2. The feedforward circuit 38 comprises: the signal splitter 12; the polarity and amplitude control circuit 16; the low-pass filter and phase control circuit 18; a 20 dB isolation pad designated R4; and, the signal combiner 34. The 20 dB pad, R4, prevents high frequency signal feedback from other parts of the receiver circuit by isolating the feedforward circuit 38 from the signal combiner 34. An example of components suitable for use in the signal splitter 12 and the signal combiner 34 in the present invention are a magic tee splitter and a magic tee combiner, respectively.

The polarity and amplitude control circuit 16 comprises: three DC signal blocking capacitors designated C2, C3 and C4; one transformer designated T3, having a primary winding 40 and a center tapped secondary winding 42; two pin diodes designated D1 and D2; a fixed resistor designated R2; a potentiometer designated R3; and, an inductor designated L1. The $V_2$ output of signal splitter 12 is connected, through C2, to one end of the primary winding 40 of T3. The other end of the primary winding 40 is connected to ground. One end of the secondary winding 42 of T3 is connected to the cathode of D1 and the other end of the secondary winding 42 is connected to the cathode of D2. The anode of D1 is connected to the anode of D2 through R3. The anodes of D1 and D2 are further connected to ground through C3 and C4, respectively. One end of a center tap lead 44 is connected to the center tap of the secondary winding 42. The other end of the center tap lead 44 is connected to the low-pass filter and phase control circuit 18 in the manner hereinafter described. The center tap lead 44 is also connected to ground through the series connection of L1 and R2. In accordance with the preferred embodiment of this invention, L1 is a radio frequency (r.f.) choke that blocks r.f. frequency signals (e.g., $V_2$), while allowing lower frequency and DC signals (e.g., $V_a$) to pass through R2 to ground. The analog control signal, $V_a$, as schematically represented in FIGURE 2, is applied to the control input of the potentiometer R3 of the polarity and amplitude control circuit 16. In practice, preferably, R3 is not included in the polarity and amplitude control circuit 16. Rather, $V_a$ is preferably a variable signal that can be applied independently to the anodes of D1 and D2.

The low-pass filter and phase control circuit 18 comprises: two DC signal blocking capacitors designated C5 and C6; two varactor diodes designated D3 and D4; and, two inductors designated L2 and L3. The center tap lead 44, described above, is connected to one side of C5. The other side of C5 is connected to one end of L2 and L3 and to the cathode of D3. The anode of D3 is connected to ground. The other end of L3 is connected to one side of C6 and to the cathode of D4. The anode of D4 is connected to ground. The other side of C6 is connected to the signal combiner 34 through the 20 dB pad, R4. The analog control signal, $V_p$, is applied to the other end of L2. In accordance with the preferred embodiment of this invention, L2 functions as a r.f. choke that blocks high frequency signals (e.g., $V_{pa}$) while passing low frequency and DC signals (e.g., $V_p$).

Turning now to a description of the operation of the feedthrough circuit 38, the capacitance of C2 is chosen such that C2 appears as a short circuit to $V_2$, which is normally a high frequency signal. Contrariwise, low frequency and DC signals are blocked by C2. As a result, C2 forms a high-pass filter that removes low frequency and DC signal components from $V_2$.

The critical elements related to the proper functioning of the polarity and amplitude control circuit 16 are the pin diodes, D1 and D2. A characteristic of pin diodes is that, in high frequency circuits, they behave like resistors. While the resistance of pin diodes is not affected by high frequency signals, their resistance can be controlled or varied by controlling or varying a DC current through the pin diodes. More specifically, the resistance of pin diodes is inversely proportional to the DC current flow through the diodes. Thus, as a DC bias voltage applied to a pin diode increases, the DC current flow through the pin diode also increases. As a result, the effective pin diode resistance, as seen by a high frequency signal, decreases. The reverse effect occurs when the DC bias voltage applied to a pin diode decreases. As is illustrated in FIGURE 2 and described above, an analog control signal, $V_a$, is applied to the anodes of D1 and D2 via R3. Thus, $V_a$ forms a DC bias voltage whose magnitude controls the DC current flow through D1 and D2 and thus, also controls the effective high frequency resistance of D1 and D2.

In accordance with this invention, varying the $V_a$ bias voltage applied to D1 and D2 controls the polarity and amplitude of the output, $V_{pa}$, of the polarity and amplitude control circuit 16. In order to better understand how varying the $V_a$ bias voltage controls the $V_{pa}$ polarity and amplitude, three different biasing arrangements are next described. First, D1 and D2 are equally biased; second, one of D1 and D2 is fully biased (i.e., on) and the other of D1 and D2 is unbiased (i.e. off); and, third, both D1 and D2 are biased on, but to different degrees.

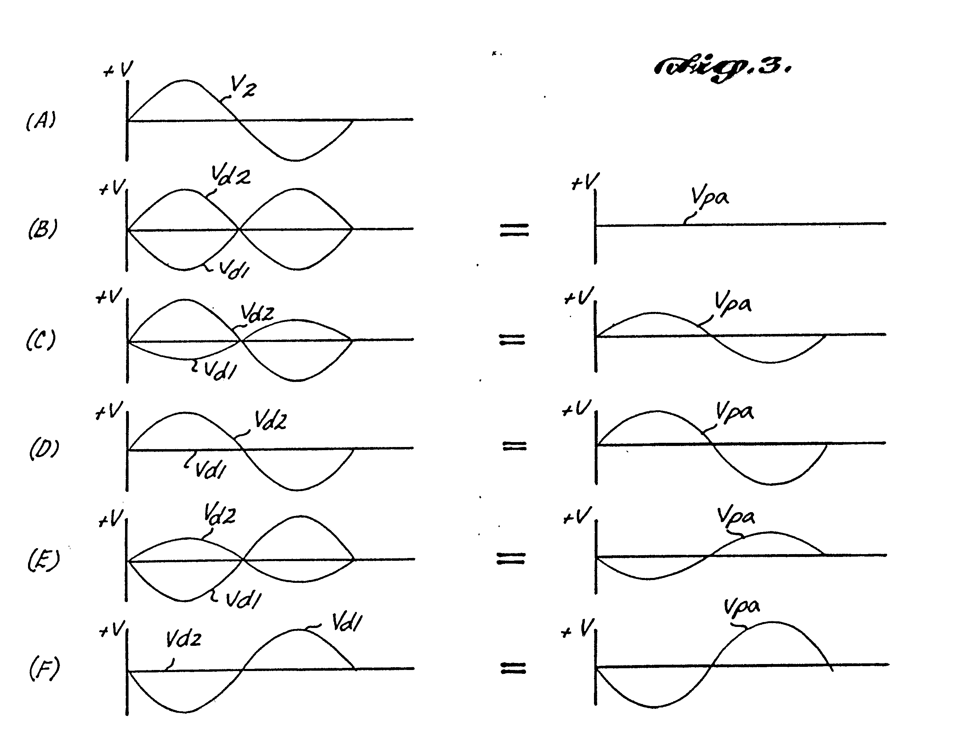

Equal biasing of D1 and D2 occurs when $V_a$ is applied equally to D1 and D2 (i.e., schematically in FIGURE 2, one-half of the $V_a$ signal is dropped

across one side of R3, and applied to the anode of D1 and the other half of the $V_a$ signal is dropped across the other side of R3, and applied to the anode of D2). The voltage on the D1 side of the secondary winding 42 is designated the $V_{d1}$ signal and the voltage on the D2 side of the secondary winding 42 is designated the $V_{d2}$ signal. The amplitudes of $V_{d1}$ and $V_{d2}$ are equal to one another whenever D1 and D2 are equally biased because the resistances seen by $V_{d1}$ and $V_{d2}$ are equal. While the amplitudes of $V_{d1}$ and $V_{d2}$ are the same, they are opposite in polarity with respect to one another since they are derived from the opposite ends of the secondary winding 42. Thus, when D1 and D2 are equally biased, $V_{d1}$ and $V_{d2}$ cancel one another at the center tap lead 44 and the resulting $V_{pa}$ signal is zero. The above relationship between $V_{d1}$, $V_{d2}$ and $V_{pa}$ are illustrated in FIGURE 3, line B.

In the second biasing arrangement mentioned above, $V_a$ is applied to only one of D1 or D2. The other of D1 or D2 is unbiased. Thus, one diode is on and the other diode is off. As a result, $V_{pa}$ is equal to either $V_{d1}$ or $V_{d2}$. For example, if D1 is biased (i.e., on) by $V_a$ and D2 is unbiased (i.e., off), D1 becomes a short circuit to ground and D2 becomes an open circuit. Because D2 is an open circuit, no $V_{d2}$ signal is produced on the D2 side of the secondary winding 42. Thus, since $V_{pa}$ is equal to the sum of $V_{d1}$ and $V_{d2}$, the resulting $V_{pa}$ signal is equal in amplitude and polarity to $V_{d1}$. This relationship is illustrated in FIGURE 3, line F.

Depending upon winding direction, the polarity at one end of the secondary winding 42 is opposite to the polarity of the primary winding 40, while the polarity of the other end of the secondary winding 42 is the same as the polarity of the primary winding 40. That is, basic transformer theory dictates that the $V_{d1}$ and $V_{d2}$ signals have opposite polarities. For purposes of this description, it is assumed that T3 is wound such that the polarity on the D1 side of the secondary winding 42 is opposite to the polarity of the primary winding 40. Thus, $V_{d1}$ is $180°$ out of phase with $V_2$ and, $V_{d2}$ is in phase with $V_2$. As a result, in the above example, $V_{pa}$ has the opposite polarity of $V_2$. This is illustrated in FIGURE 3, lines A and F. If the situation in the above example is reversed; namely, D1 is unbiased and D2 is biased by $V_a$, $V_{pa}$ is equal in amplitude and polarity to $V_{d2}$, because there is no $V_{d1}$ signal. Because the polarity on the D2 side of the secondary winding 42 is the same as the primary winding 40, $V_{pa}$ has the same polarity as $V_2$. This relationship is illustrated in FIGURE 3, lines A and D. In summary, by biasing only one of D1 or D2 it is possible to produce a $V_{pa}$ signal that is equal in amplitude to, and in phase with, $V_{d1}$ or $V_{d2}$; and has either the same or opposite polarity as $V_2$. The importance of having the flexibility to produce a $V_{pa}$ signal having either the same or opposite polarity as $V_2$ is discussed next.

When the first stage mixer 30 mixes $V_s$ with $V_1{'}$, the mixer 30 may or may not reverse the polarity of $V_1{'}$. Such a polarity reversal by mixer 30 is dependent upon the mixer design and construction. For example, a component mismatch in the four diode ring of the mixer 30 will cause a phase shift in the $V_1{'}$ components of between 0-360°. Obviously, a $180°$ phase shift amounts to a polarity reversal of the $V_1{'}$ component. Therefore, the feedforward circuit 38 must be capable of reversing the polarity of $V_2{'}$ so that $V_2{'}$ can oppose the $V_1{'}$ components of the $V_m{'}$ signal. The feedforward circuit 38 accomplishes the polarity reversal of $V_2{'}$ in the manner described above.

The third biasing arrangement of D1 and D2, namely unequal biasing of both D1 and D2, is discussed next. Unequal biasing of D1 and D2 results in unequal resistance values of D1 and D2. The unequal resistances of D1 and D2 results in unequal amplitudes of the $V_{d1}$ and $V_{d2}$ signals. Because $V_{d1}$ and $V_{d2}$ have opposite polarities, as discussed above, combining $V_{d1}$ and $V_{d2}$ results in incomplete cancellation of the two signals. The resulting $V_{pa}$ signal will have a polarity equal to the polarity of either $V_{d1}$ or $V_{d2}$, determined by whichever signal has the greater amplitude. The amplitude of $V_{pa}$ will be equal to the difference between the amplitudes of $V_{d1}$ and $V_{d2}$. This relationship can be seen by comparing the waveforms depicted in FIGURE 3, lines C and E. For example, if less biasing voltage (i.e., $V_a$) is applied to D1 than is applied to D2, D1 will have a higher resistance than D2. As a result, the amplitude of $V_{d1}$ will be less than the amplitude of $V_{d2}$. The resulting $V_{pa}$ signal will be in-phase with $V_{d2}$ (since $V_{d2} > V_{d1}$) and the amplitude of $V_{pa}$ will equal the amplitude of $V_{d2}$ reduced by the amplitude of $V_{d1}$. See FIGURE 3, line C. Obviously, if the biasing of D1 and D2 is reversed, $V_{pa}$ will be less than, but in-phase with, $V_{d1}$. See FIGURE 3, line E. Thus, unequal biasing of D1 and D2 provides both polarity and amplitude control of $V_{pa}$. The importance of polarity control was discussed above. The importance of amplitude control of $V_{pa}$ is discussed next.

In general, the amount of local oscillator feedthrough (i.e., the $V_1{'}$ component of $V_m$) is a function of the $V_{LO}$ signal frequency, the $V_s$ signal frequency, the inability of imperfect mixers to reject the local oscillator feedthrough and the design of the I.F. filter 36. As stated above, since no filters are perfect, some signals near the filter pass band cutoff are passed. Introducing amplitude control in the polarity and amplitude control circuit 16, allows the amplitude of the $V_{pa}$ signal to be adjusted to equal the amplitude of the $V_1{'}$ component of the $V_m{'}$ signal.

As a result of the aforementioned polarity and amplitude adjustments to $V_{pa}$, the polarity and amplitude control circuit 16 causes a slight phase shift in $V_{pa}$. The phase shift is inherent in the operation of the D1 and D2 configuration described above. In accordance with this invention, the phase difference between $V_{pa}$ and the $V_1'$ component of $V_m'$ is corrected by the low-pass filter and phase control circuit 18, whose operation is described next.

The key elements of the low-pass filter and phase control circuit 18 are the varactor diodes D3 and D4. As will be discussed below, D3 and D4 combine with L3 to form a tunable low-pass filter. varactor diodes have a capacitance value that varies as a function of the bias voltage applied to their cathodes. Thus, in the preferred embodiment of the invention, the capacitance of D3 and D4 can be varied by varying the $V_p$ signal. Varying the capacitance of D3 and D4 tunes the low-pass filter by moving the corner frequency (i.e., high frequency cutoff) of the low-pass filter and phase control circuit 18. As will be described below, moving the corner frequency provides phase shift control in the low-pass filter and phase control circuit 18.

It is well-known in the filtering art that filtered signals are subjected to increasing amounts of phase shift as the frequency of the filtered signal approaches the corner frequency of a filter. It follows that the degree of phase shift applied to a signal can be controlled by controlling the location of the corner frequency of the filter. In the present invention, this phenomenon is used to control the phase shifting of $V_{pa}$ signals. More specifically, the corner frequency of the low-pass filter and phase control circuit 18 is moved to control the phase shifting of $V_{pa}$ signals. The degree to which the corner frequency is moved is determined by the amount of phase shift desired, which, in turn, is controlled by the magnitude of $V_p$. In accordance with the invention, the microprocessor 24 adjusts $V_p$ so that the $V_{pa}$ phase shift created by the low-pass filter and phase control circuit 18 will compensate for the phase difference between $V_{pa}$ and the $V_1'$ component contained in $V_m'$.

Phase shifting $V_{pa}$ in the manner described above results in a slight amplitude change in $V_{pa}$. In accordance with the preferred embodiment of the invention, the amplitude change introduced by the low-pass filter and phase control circuit 18 is compensated for by the polarity and amplitude control circuit 16. More specifically, as discussed more fully below, the microprocessor 24 detects the changed amplitude of the $V_{pa}$ signal by detecting a changed local oscillator feedthrough signal after $V_p$ has been varied to change the phase shift created by the low-pass filter and phase control circuit. When this occurs, the microprocessor 24 issues control signals (via $V_a$) to the polarity and amplitude control circuit 16 that causes a compensating change in the amplitude of $V_{pa}$.

As stated above, the microprocessor 24 monitors the local oscillator feedthrough (i.e., $V_1'$ component) in the output signal, $V_x$, of the superheterodyne receiver. The microprocessor 24 measures the $V_1'$ component during a calibration phase, which typically occurs when the instrument is powered on. Alternatively, or in addition, the calibration phase may be initiated by a user via a keyboard entry to the microprocessor 24. Likewise, an automatic calibration feature may reinitiate the calibration phase periodically. During the calibration phase, the microprocessor 24 tunes the local oscillator 10 to the center frequency of the first stage I.F. filter 36. In accordance with the preferred embodiment of the invention, this tuned local oscillator frequency (i.e., $V_{LO}$) corresponds to a 0 Hz $V_{in}$ signal. During the calibration phase a suitable means for blocking the $V_{in}$ signal is implemented. An example of such a blocking means is a relay switch that open circuits the appropriate inputs to the mixer 30. Hence, during the calibration phase, the $V_x$ signal consists entirely of the $V_1'$ component of $V_m'$. The microprocessor 24 determines the magnitude of the $V_1'$ component and uses the magnitude information to control the feedforward circuit 38 in the manner described next.

In accordance with the invention, the microprocessor 24 applies an iterative and interactive control algorithm to control the feedforward circuit 38. Having once determined the amount of the $V_1'$ component that is to be nulled, as discussed above, the microprocessor 24 will vary $V_a$, i.e., $V_a$ will be increased or decreased. The polarity and amplitude control circuit 16 will respond to the varied $V_a$ signal and adjust the amplitude of $V_{pa}$ in the manner described above. After $V_{pa}$ has been adjusted, the microprocessor 24 will look for a change in the $V_1'$ component of $V_x$. If a reduction in the $V_1'$ component is detected, $V_a$ will be varied in the same direction (i.e., increased or decreased). This process will be repeated until the $V_1'$ component is minimized. Alternatively, if the $V_1'$ component increases, when $V_a$ is first varied, the next $V_a$ change will be in the opposite direction, e.g., $V_a$ will be decreased if it was increased or increased if it was decreased. This is the iterative aspect of the control algorithm used by the microprocessor 24 and is equally applicable to the microprocessor 24 adjustments to $V_p$. Either after the $V_1'$ component has been minimized by changing $V_a$, or after each change in $V_a$, the microprocessor 24 will change $V_p$ and detect its effect on the $V_1'$ component of $V_m'$. As with $V_a$ changes, $V_p$ changes will take place until $V_p$ changes have no further effect on the magnitude of the $V_1'$ component, or the $V_1'$ component magnitude drops below an acceptable val-

ue. If the $V_1'$ component is not below an acceptable value, $V_a$ will be changed to see if a lower $V_1'$ component value can be achieved. The back and forth shift between $V_a$ and $V_p$ changes continues until the $V_1'$ value drops below an acceptable level. The back and forth shift between $V_a$ and $V_p$ changes is the interactive feature of the microprocessor control algorithm. The minimized local oscillator feedthrough value is preferably preset by a manufacturer of the invention.

As can be readily appreciated from the foregoing description, the invention provides a feedforward method and apparatus for nullifying the local oscillator feedthrough in a superheterodyne receiver, particularly in a superheterodyne receiver used to detect low frequency signals. While a preferred embodiment of the invention has been illustrated and described herein, it is to be understood that, within the scope of the appended claims, various changes can be made. For example, variable resistors might be applied in place of the pin diodes D1 and D2 in the polarity and amplitude control circuit 16 and the tunable low-pass filter and phase control circuit 18 could be formed from switchable banks of inductors and capacitors. Likewise, a mixer 30 could be designed to incorporate the feedforward circuit 38 and recombine the $V_2'$ and $V_m$ signals ahead of the I.F. amplifier 32. Further, many other software approaches might be employed, other than the algorithm described above, for monitoring and controlling the $V_a$ and $V_p$ control signals. Hence, the invention can be practiced otherwise than as specifically described herein.

## Claims

1. An apparatus for nulling local oscillator feedthrough produced when mixing an incoming signal with a local oscillator signal, said apparatus comprising:

(A) splitting means for receiving a local oscillator signal and splitting said local oscillator signal into first and second signals;

(B) mixing means coupled to said splitting means for receiving said first signal, mixing said first signal with an input signal and producing a mixed signal having a local oscillator feedthrough component;

(C) bypassing means coupled to said splitting means for receiving said second signal and modifying said second signal so as to produce a nullifying signal that is, substantially, opposite in polarity, equal in magnitude and in phase with said local oscillator feedthrough component of the mixed signal of said mixing means; and,

(D) combining means coupled to said mixing means and said bypassing means for combining the mixed signal of said mixing means with said nullifying signal.

2. The apparatus for nulling local oscillator feedthrough claimed in Claim 1, wherein said bypassing means includes:

(A) polarity reversing and amplitude adjusting means for reversing the polarity and adjusting the amplitude of said second signal; and,

(B) phase shifting means for shifting the phase of said second signal.

3. The apparatus for nulling local oscillator feedthrough claimed in Claim 2, wherein said bypassing means includes control means for controlling: (i) said polarity reversing and amplitude means: and, (ii) said phase shifting means.

4. The apparatus for nulling local oscillator feedthrough claimed in Claim 3, wherein said polarity reversing and amplitude adjusting means comprises:

(A) a transformer having a primary winding connected to receive said second signal from said splitting means and, a center tapped secondary winding;

(B) two pin diodes, each of said pin diodes having a first lead and a second lead, said first lead of one of said diodes connected to one side of said center tapped secondary winding of said transformer and said first lead of the other of said diodes connected to another side of said center tapped secondary winding of said transformer, said second leads of said diodes connected to one another; and

(C) a plurality of analog control signals, produced by said control means, said plurality of analog control signals applied to said second leads of said pin diodes.

5. The apparatus for nulling local oscillator feedthrough claimed in Claim 4, wherein said phase shifting means comprises a low-pass filter.

6. The apparatus for nulling local oscillator feedthrough claimed in Claim 5, wherein said low-pass filter includes:

(A) an inductor;

(B) two varactor diodes, each of said varactor diodes having a first lead and a second lead, said first lead of one of said varactor diodes connected to one end of said inductor and said first lead of the other of said varactor diodes connected to the other end of said inductor, said second leads of said varactor diodes connected to ground; and,

(C) an analog control signal produced by said control means, said analog control signal applied to said first lead of one of said varactor diodes, and through said inductor to said first lead of the other of said varactor diodes.

7. The apparatus for nulling local oscillator feedthrough claimed in Claim 6, wherein said control means further comprises:

(A) a microprocessor based controller for producing digital control signals; and

(B) a plurality of digital-to-analog converters for converting said digital control signals to said analog control signals for controlling said polarity reversing and amplitude adjusting means and said phase shifting means.

8. The apparatus for nulling local oscillator feedthrough claimed in Claim 7, wherein said analog control signal for controlling said polarity reversing and amplitude adjusting means is a biasing voltage applied to said pin diodes, and said analog control signal for controlling said phase shifting means is a biasing voltage applied to said varactor diodes.

9. The apparatus for nulling local oscillator feedthrough claimed in Claim 7, wherein said controlling means utilizes an iterative and interactive algorithm approach to controlling said polarity, amplitude and phase of said nullifying signal by varying said analog control signals produced by said digital-to-analog converters.

10. The apparatus for nulling local oscillator feedthrough claimed in Claim 9, wherein said splitting means is a magic tee signal splitter and said combining means is a magic tee signal combiner.

11. A method for nulling local oscillator feedthrough produced when mixing an output signal with a local oscillator signal comprising the steps of:

(A) splitting the local oscillator signal into first and second signals;

(B) mixing said first signal with an input signal and producing a mixed signal having a local oscillator feedthrough component;

(C) modifying said second signal so that:
(i) the polarity of said second signal is opposite the polarity of said local oscillator feedthrough component contained in said mixed signal;
(ii) the amplitude of said second signal is equal to the amplitude of said local oscillator feedthrough component contained in said mixed signal; and,
(iii) the phase of said second signal is in-phase with said local oscillator feedthrough component contained in said mixed signal; and,

(D) combining said modified second signal with said mixed signal.

12. The method for nulling local oscillator feedthrough claimed in Claim 11, wherein the polarity and amplitude of said second signal is modified by:

(A) splitting said second signal into two secondary signals;

(B) adjusting the amplitude of each of said secondary signals; and,

(C) recombining said secondary signals.

13. The method for nulling local oscillator feedthrough claimed in Claim 11, wherein the phase of said second signal is modified by adjusting the knee of a low-pass filter.

14. The method for nulling local oscillator feedthrough claimed in Claim 11, wherein said step of modifying said second signal is controlled by:

(A) monitoring said local oscillator feedthrough component contained in an output signal; and,

(B) applying an iterative and interactive approach to adjusting the amplitude of said secondary signals and to moving said knee of said low-pass filter.

15. In a superheterodyne receiver that includes a local oscillator and a mixing means for mixing an input signal and a signal from said local oscillator and producing a mixed signal containing components of said local oscillator signal, the improvement comprising:

(A) splitting means for receiving a local oscillator signal and splitting said local oscillator signal into first and second signals;

(B) mixing means coupled to said splitting means for receiving said first signal, mixing said first signal with an input signal and producing a mixed signal having a local oscillator feedthrough component;

(C) bypassing means coupled to said splitting means for receiving said second signal and modifying said second signal so as to produce a nullifying signal that is, substantially, opposite in polarity, equal in magnitude and in phase with said local oscillator feedthrough component of the mixed signal of said mixing means; and,

(D) combining means coupled to said mixing means and said bypassing means for combining the mixed signal of said mixing means with said nullifying signal.

16. The improved superheterodyne receiver claimed in Claim 15, wherein said bypassing means includes:

(A) polarity reversing and amplitude adjusting means for reversing the polarity and adjusting the amplitude of said second signal; and,

(B) phase shifting means for shifting the phase of said second signal.

17. The improved superheterodyne receiver claimed in Claim 16, wherein said bypassing means includes control means for: (i) said polarity reversing and amplitude adjusting means; and, (ii) said phase shifting means.

18. The improved superheterodyne receiver claimed in Claim 17, wherein said polarity reversing and amplitude adjusting means comprises:

(A) a transformer having a primary winding connected to receive said second signal from said splitting means and, a center tapped secondary winding;

(B) two pin diodes, each of said pin diodes having a first lead and a second lead, said first lead of one of said diodes connected to one side of said center tapped secondary winding of said transformer and said first lead of the other of said diodes connected to another side of said center tapped secondary winding of said transformer, said second leads of said diodes connected to one another; and,

(C) a plurality of analog control signals produced by said control means, said plurality of analog control signals applied to said second leads of said pin diodes.

19. The improved superheterodyne receiver claimed in Claim 18, wherein said phase shifting means comprises a low-pass filter.

20. The improved superheterodyne receiver claimed in Claim 19, wherein said low-pass filter .includes:

(A) an inductor;

(B) two varactor diodes, each of said varactor diodes having a first lead and a second lead, said first lead of one of said varactor diodes connected to one end of said inductor and said first lead of the other of said varactor diodes connected to the other end of said inductor, said second leads of said varactor diodes connected to ground; and,

(C) an analog control signal produced by said control means, said analog control signal applied to said first lead of one of said varactor diodes, and through said inductor to said first lead of the other said varactor diodes.

21. The improved superheterodyne receiver claimed in Claim 20, wherein said control means further comprises:

(A) a microprocessor based controller for producing digital control signals; and,

(B) a plurality of digital-to-analog converters for converting said digital control signals to said analog control signals for controlling said polarity reversing and amplitude adjusting means and said phase shifting means.

22. The improved superheterodyne receiver claimed in Claim 21, wherein said analog control signal for controlling said polarity reversing and amplitude adjusting means is a biasing voltage applied to said pin diodes, and said analog control signal for controlling said phase shifting means is a biasing voltage applied to said varactor diodes.

23. The improved superheterodyne receiver claimed in Claim 21, wherein said controlling means utilizes an iterative and interactive algorithm approach to controlling said polarity, amplitude and phase of said nullifying signal by varying said analog control signals produced by said digital-to-analog converters.

24. The improved superheterodyne receiver claimed in Claim 23, wherein said splitting means is a magic tee signal splitter and said combining means is a magic tee signal combiner.

**Fig. 1.**

EP 0 338 125 A1

*Fig. 2.*

Fig.3.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-C-3 344 318 (ANT)<br>* Whole document * | 1-3,11-13,15-17 | H 03 D 7/00<br>H 04 B 1/12 |
| Y | | 14 | |
| | --- | | |
| Y | EP-A-0 243 733 (ANT)<br>* Page 2, line 1 - page 6, line 31; figures 1-4 * | 14 | |

TECHNICAL FIELDS SEARCHED (Int. Cl.4)

H 03 D
H 04 B
H 03 G

The present search report has been drawn up for all claims

| Place of search | Date of completion of the search | Examiner |
|---|---|---|
| THE HAGUE | 25-01-1989 | DHONDT I.E.E. |